# FASCICULE DE BREVET EUROPEEN

(11) **EP 2 865 030 B1**
(45) Date de publication et mention de la délivrance du brevet: **11.03.2020**
(21) Numéro de dépôt: 13765425.7
(22) Date de dépôt: 21.06.2013
(51) Int. Cl.: H01L 51/44

(54) **PHOTODÉTECTEUR INTÉGRANT DES MOYENS DE CONCENTRATION DU RAYONNEMENT LUMINEUX ET MATRICE CORRESPONDANTE**
PHOTODETEKTOR MIT EINGEBAUTEM MITTEL ZUR KONZENTRATION EINER SICHTBAREN STRAHLUNG UND ENTSPRECHENDES ARRAY
PHOTODETECTOR HAVING A BUILT-IN MEANS FOR CONCENTRATING VISIBLE RADIATION AND CORRESPONDING ARRAY

(30) Priorité: 21.06.2012 FR 1255858
(43) Date de publication de la demande: 29.04.2015
(73) Titulaire: Commissariat à l'Énergie Atomique et aux Énergies Alternatives, 75015 Paris (FR); ISORG, 38040 Grenoble Cedex 09 (FR)
(72) Inventeur: BENWADIH, Mohammed, F-94500 Champigny/Marne (FR); DAAMI, Anis, Bembla (5021) (TN); TALLAL, Jamal, 76410 Saint Aubin Les Elbeuf (FR)
(74) Mandataire: Gevers & Orès
(86) Numéro de dépôt international: PCT/IB2013/055108
(87) Numéro de publication internationale: WO 2013/190515

(56) Documents cités:
- US-A1- 2009 255 586
- US-A1- 2012 125 413
- WANG D H ET AL: "Effect of the ordered 2D-dot nano-patterned anode for polymer solar cells", ORGANIC ELECTRONICS, ELSEVIER, AMSTERDAM, NL, vol. 11, no. 2, 10 novembre 2009 (2009-11-10), pages 285-290, XP026836252, ISSN: 1566-1199 [extrait le 2009-11-10]

## Description

L'invention concerne le domaine des photodétecteurs organiques.

Le principe de fonctionnement d'un tel photodétecteur est de capter les rayons lumineux qu'il reçoit et de les convertir en courant électrique.

Un photodétecteur comprend classiquement une couche active située entre deux électrodes, l'empilement étant déposé sur un substrat, notamment un substrat de verre.

Un photon arrivant sur la couche active va être dissocié en une paire d'électron/trou. Cette dernière sera séparée du fait de l'application d'un champ électrique externe. Ainsi, les électrons seront collectés par l'électrode positive et les trous par l'électrode négative, un courant électrique étant alors généré.

Les premiers photodétecteurs ont été obtenus en mettant en oeuvre des technologies silicium.

Plus récemment, ont été développés des photodétecteurs intégrant des matériaux organiques. En effet, ceux-ci peuvent être facilement mis en oeuvre sur de larges surfaces et ils présentent des performances comparables à celles du silicium. Enfin, les photodétecteurs sont d'un coût de fabrication relativement bas, du fait de la technologie sur substrat souple qui est mise en œuvre.

Un tel photodétecteur organique peut présenter une structure horizontale. On peut notamment se référer à cet égard au document US 2005/0179031. Il peut également présenter une structure verticale, comme illustré par le document US 2006/0060239.

A ce jour, la structure la plus communément utilisée consiste en un empilement vertical de couches organiques et non organiques.

Ces photodétecteurs organiques ont des performances limitées. Des solutions ont donc été recherchées pour augmenter leur rendement.

Cette augmentation passe par l'optimisation de la collecte de la lumière incidente de façon à pouvoir convertir un maximum de photons en paires d'électron/trou et ainsi collecter un maximum d'électrons et de trous aux électrodes pour augmenter le courant électrique généré.

Les solutions proposées dans l'état de la technique consistent à prévoir des lentilles sur le photodétecteur, de façon à concentrer sur ce dernier le rayonnement lumineux. Il est notamment fait référence à l'article de Y. Ishihara et al. « A high photosensitivity IL-CCD image sensor with monolithic resin lens array », IEEE 1983, 497-500.

Ces solutions permettent d'apporter un gain d'environ 25% par rapport à un photodétecteur sans lentille et elles apportent satisfaction.

Cependant, la présence de ces lentilles complique la fabrication du dispositif obtenu puisqu'elle comporte une étape spécifique. De plus, cette étape doit être réalisée de façon à obtenir des lentilles présentant les mêmes propriétés optiques. Ceci augmente donc son coût.

Le document US 2012/0125413 A1 divulgue un photodétecteur organique. Ce photodétecteur n'intègre pas des moyens pour concentrer le rayonnement lumineux dans la couche active.

Le document WANG D H et al. « Effect of the ordered 2D-dot nano-patterned anode for polymer solar cells" Organic electronic, elseviern vol. 11, no. 2, 2009 divulgue un photodétecteur organique. Ce photodétecteur n'intègre pas des moyens pour concentrer le rayonnement lumineux dans la couche active.

Le document US 2009/0255586 A1 divulgue un photodétecteur organique. Ce photodétecteur n'intègre pas des moyens pour concentrer le rayonnement lumineux dans la couche active.

L'invention a pour objet de pallier ces inconvénients en proposant un photodétecteur dont les performances sont augmentées et qui peut être obtenu par un procédé de fabrication simple à mettre et qui est donc d'un coût relativement faible.

Ainsi, l'invention concerne dans un premier mode de réalisation, un photodétecteur organique susceptible d'être exposé à un rayonnement lumineux, comprenant une première électrode plane et formée sur un substrat plan, une couche active convexe, formée sur la première électrode, et une deuxième électrode se présentant sous forme d'une couche qui épouse la forme extérieure de la couche active convexe et qui présente une forme convexe de sorte que la deuxième électrode agit comme une lentille convergente, des moyens pour concentrer le rayonnement lumineux dans la couche active étant intégrés dans le photodétecteur et étant représentés par la deuxième électrode.

Dans ce cas, la couche active est déposée sur la première électrode et l'enrobe, tandis que la deuxième électrode déposée sur la couche active est convexe. La deuxième électrode agit comme une lentille convergente et les moyens pour concentrer le rayonnement lumineux dans la couche active sont représentés par la deuxième électrode.

De façon avantageuse, la première électrode ainsi que le substrat sont transparents et la deuxième électrode est réfléchissante.

On peut également prévoir que la première électrode soit métallique et la deuxième électrode transparente.

Dans un deuxième mode de réalisation, le substrat est transparent, la première électrode est évidée pour former une cavité convexe et la couche active est disposée dans cette cavité. La cavité comprend une paroi ayant une surface convexe de sorte que la surface convexe de la paroi agit comme une lentille convergente et les moyens pour concentrer le rayonnement lumineux dans la couche active sont représentés par ladiet surface convexe de la paroi de ladite cavité.

Dans un troisième mode de réalisation, le photodétecteur organique comprend une première électrode formée sur un substrat plan, une couche active convexe, formée sur la première électrode, et une deuxième électrode formée sur la couche active convexe, des moyens pour concentrer le rayonnement lumineux dans la couche active étant intégrés dans le photodétecteur, dans lequel le substrat est transparent et évidé pour former une cavité convexe comprenant une surface convexe, la première électrode est convexe et consiste en une couche déposée dans ladite cavité convexe de sorte que la surface convexe de la cavité agit comme une lentille convergente et la couche active est également déposée dans la cavité, sur la première électrode, et dans lequel lesdits moyens étant représentés par la surface convexe de ladite cavité.

Ces trois modes de réalisation de l'invention visent à résoudre le même problème technique, à savoir l'intégration dans le photodétecteur de moyens de concentration du rayonnement dans la couche active.

Dans le cas où la couche active est présente dans une cavité formée dans la première électrode ou dans le substrat, la deuxième électrode est plane.

Dans ce cas également, un isolant électrique est avantageusement prévu entre les première et deuxième électrodes.

L'invention concerne également une matrice comportant une pluralité de photodétecteurs selon l'invention.

Lorsque les photodétecteurs comportent une couche active dans une cavité formée dans la première électrode ou dans le substrat, la première électrode peut être commune à tous les photodétecteurs.

Dans une variante de réalisation de cette matrice, les photodétecteurs peuvent être isolés électriquement les uns des autres.

L'invention sera mieux comprise et d'autres buts, avantages et caractéristiques de celle-ci apparaîtront plus clairement à la lecture de la description qui suit et qui est faite au regard des dessins annexés, sur lesquels :
- la figure 1 est une vue en coupe d'un photodétecteur selon l'invention, dans lequel les moyens de concentration du rayonnement lumineux consistent en un miroir,
- les figures 2 à 4 sont des vues en coupe de photodétecteurs selon l'invention, dans lesquels les moyens de concentration du rayonnement lumineux consistent en une lentille,
- les figures 5 et 6 sont des vues en coupe illustrant schématiquement une matrice comportant des photodétecteurs selon l'invention qui intègrent une lentille, cette matrice présentant une électrode commune pour tous les photodétecteurs,
- la figure 7 est une vue en coupe d'une matrice comportant des photodétecteurs selon l'invention qui intègrent une lentille et qui sont tous isolés électriquement les uns des autres, et
- la figure 8 est une vue en coupe d'une matrice comportant des photodétecteurs selon l'invention qui intègrent un miroir et qui présentent une électrode commune.

Les éléments communs aux différentes figures seront désignés par les mêmes références.

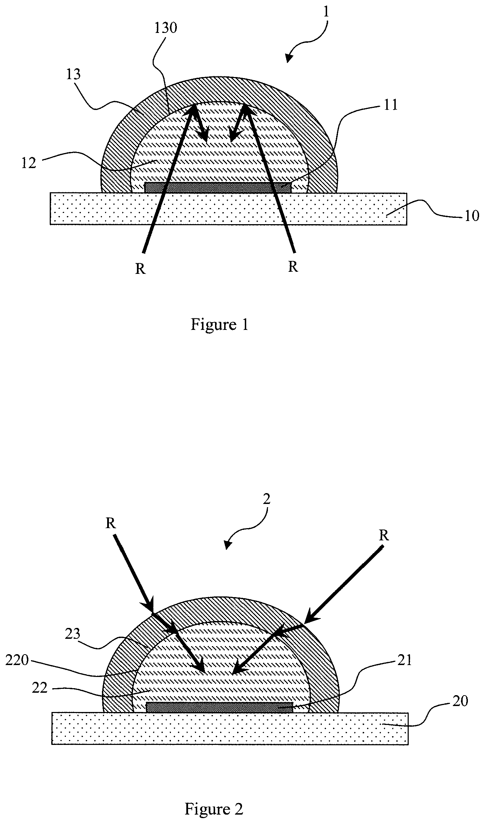

La figure 1 illustre un premier mode de réalisation du photodétecteur selon l'invention, qui intègre des moyens de concentration du rayonnement lumineux ayant une fonction de miroir.

Ce photodétecteur 1 comporte un substrat 10 plan et transparent. Ce substrat est indifféremment flexible ou rigide. Il peut notamment être réalisé en verre ou en une matière plastique, par exemple du polyéthylène naphthalate ou du polyéthylène téréphtalate.

Sur ce substrat 10, est déposée une électrode 11 elle-même transparente. Cette électrode conductrice 11 peut notamment être réalisée en oxyde d'indium-étain (ITO dans la terminologie anglaise) ou encore en oxyde de zinc (ZnO), en oxyde d'antimoine d'étain (ATO), en oxyde de gallium de zinc (GZO) ou en oxyde d'aluminium de zinc (AZO). Comme l'illustre la figure 1, l'électrode 11 est déposée localement sur le substrat et son épaisseur est relativement faible.

Cette électrode 11 est plane et elle est enrobée dans une coche active 12 de forme convexe ou encore semi-sphérique.

La couche active comporte un matériau accepteur d'électrons et un matériau donneur d'électrons, comme le PEDOTPSS.

Elle peut consister en une hétérojonction de ces deux matériaux, se présentant sous la forme d'une couche ou d'un empilement de plusieurs couches.

Enfin, le photodétecteur 1 comporte une deuxième électrode 13 se présentant sous la forme d'une couche qui épouse la forme extérieure de la couche active 12 et qui présente donc également une forme convexe.

L'électrode 13 présente un pouvoir réfléchissant au moins au niveau de son interface semi-sphérique 130 avec la couche active 12.

Ainsi, cette électrode 13 peut être une électrode métallique. Elle peut notamment être réalisée en argent ou en aluminium.

Cette électrode 13 peut également être réalisée en un matériau quelconque, dans la mesure où une couche d'un matériau réfléchissant est disposée au niveau de l'interface 130 entre l'électrode 13 et la couche active 12. Cette couche réfléchissante peut notamment être une couche métallique. Elle peut notamment être réalisée en Ag, Ni ou Cr.

A titre d'illustration, les épaisseurs des différentes couches sont comprises entre 100 et 250 nm. La surface extérieure des couches 12 et 13 est comprise entre 100 µm² et 1 mm².

Le photodétecteur fonctionne de la façon suivante.

Son substrat 10 est exposé à un rayonnement lumineux, symbolisé par les flèches identifiées R sur la figure 1. Dans la mesure où un faisceau lumineux a traversé la couche active 12, sans avoir été absorbé, il se réfléchit sur l'électrode 13 et traverse de nouveau la couche active.

Cette réflexion obtenue grâce à la deuxième électrode 13 réflectrice permet d'augmenter le nombre de photons susceptibles d'être dissociés en une paire d'électron/trou. En effet, certains photons peuvent traverser la couche active sans avoir été absorbés. La performance du photodétecteur est donc ainsi augmentée.

La figure 2 est une vue en coupe d'un autre mode de réalisation du photodétecteur selon l'invention dont la structure intègre des moyens permettant de concentrer le rayonnement lumineux dans la couche active. Son dimensionnement est identique à celui du photodétecteur illustré à la figure 1.

Ce photodétecteur 2 comporte un substrat 20 transparent sur lequel est formée une première électrode 21 qui est plane. Comme l'illustre la figure 2, l'électrode ne recouvre pas complètement le substrat. Comme pour le photodétecteur 1, elle résulte d'un dépôt localisé sur le substrat 20 d'un matériau constitutif.

L'électrode 21 est enrobée dans une couche active 22 qui présente une forme semi-sphérique, sa surface extérieure 220 ayant donc une forme convexe.

Enfin, une deuxième électrode 23 est formée sur la couche active 22. Elle se présente sous la forme d'une couche d'épaisseur sensiblement constante qui épouse la forme convexe de la surface extérieure 220 de la couche active 22. Cette électrode 23 est transparente.

Un traitement de mouillabilité peut être prévu sur la couche active 22 avant la formation de la deuxième électrode. Un tel traitement permet d'assurer une couverture complète de la couche 22 par la deuxième électrode.

Le fonctionnement du photodétecteur 2 est le suivant.

La deuxième électrode 23 est exposée à un rayonnement lumineux, symbolisé par les flèches référencées R sur la figure 2.

La seconde électrode 23 agit alors comme une lentille convergente de façon à concentrer les rayons lumineux sur la couche active 22.

De plus, si l'électrode 21 présente un pouvoir réfléchissant, elle est susceptible de renvoyer dans la couche active, les photons qui l'auraient traversée sans avoir été absorbés. La performance du photodétecteur est alors optimisée. L'électrode 21 peut notamment être réalisée en métal.

Ainsi, le photodétecteur 2 comporte une seconde électrode qui fonctionne comme une lentille convergente, afin d'augmenter son rendement.

Le rendement est encore davantage augmenté lorsque la première électrode a un pouvoir réfléchissant.

On peut considérer que ce photodétecteur présente sensiblement les mêmes performances qu'un photodétecteur plan sur lequel serait prévue une lentille, fabriquée indépendamment. Cependant, sa fabrication est simplifiée puisque la lentille est intégrée dans le photodétecteur et son coût d'obtention est donc inférieur à celui d'un photodétecteur plan auquel serait associée une lentille fabriquée indépendamment.

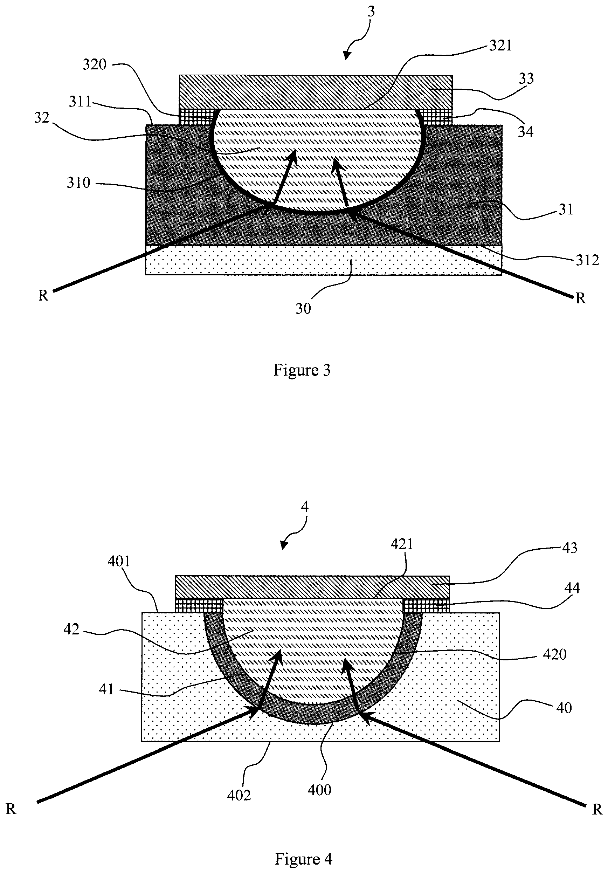

La figure 3 est une vue en coupe d'un photodétecteur 3 selon un deuxième mode de réalisation de l'invention qui comporte également une lentille directement intégrée dans sa structure.

Le photodétecteur 3 comporte un substrat 30 transparent. Ce substrat peut être ou non flexible.

Sur ce substrat 30, est déposée une électrode 31.

Cette électrode 31 est plane. Cependant, contrairement aux modes de réalisation illustrés sur les figures 1 et 2, elle recouvre entièrement le substrat et son épaisseur est importante. En effet, cette électrode 31 est gravée pour former une cavité de forme convexe.

Par ailleurs, cette électrode 31 est réalisée en un matériau transparent.

Dans la cavité formée dans l'électrode 31, est déposée une couche active 32. Cette couche active épouse donc la forme convexe de la paroi 310 de la cavité formée dans la première électrode 31.

La paroi 310 peut subir un traitement de mouillabilité avant le dépôt de la couche active 32. Ceci permet de bien recouvrir la paroi 310 avec la couche active.

Comme illustré sur la figure 3, la couche active 32 est formée de façon à s'étendre au-delà de la face 311 de la première électrode 31, opposée à la face 312 en contact avec le substrat 30. C'est sur cette face 311 que débouche la cavité formée dans la première électrode.

Ainsi, la partie active 32 présente une paroi convexe 320 qui est en contact avec la totalité de la surface convexe de la paroi 310 de la cavité réalisée dans la première électrode 31. La couche active comporte également une paroi sensiblement plane 321 qui ferme la paroi convexe 320.

Cette paroi plane s'étend au-delà de la surface 311 de la première électrode 31. C'est sur cette surface 321 qu'est formée la deuxième électrode 33. Elle se présente sous la forme d'une couche plane et d'épaisseur sensiblement constante.

Comme l'illustre la figure 3, les deux électrodes 31 et 33 sont isolées l'une de l'autre au moyen d'un isolant 34.

A titre d'illustration, l'épaisseur des différentes couches est comprise entre 100 et 250 nm et la surface de la paroi 310 est comprise entre 100 µm² et 1 mm².

Le fonctionnement du photodétecteur 3 est le suivant.

Le substrat 30 est exposé à un rayonnement lumineux qui est illustré par les deux flèches référencées R sur la figure 3. Le substrat 30 et la première électrode 31 étant transparents, le rayonnement lumineux les traverse. La forme convexe de la paroi 310 agit sur les rayons lumineux comme une lentille convergente de façon à concentrer la lumière dans la couche active 32. Ainsi, le photodétecteur 3 comporte, intégrée dans sa structure, une lentille qui est obtenue lors de sa fabrication. Les performances du photodétecteur 3 sont alors augmentées.

Dans la mesure où la deuxième électrode 33 est réflectrice, elle agit comme un miroir. Elle est alors susceptible de renvoyer dans la couche active les rayons lumineux qui l'auraient traversée sans avoir été absorbés. Les performances du photodétecteur 3 sont de ce fait encore accrues.

Ceci est notamment le cas lorsque l'électrode 3 est réalisée un matériau métallique ou lorsqu'elle comporte une couche réflectrice sur sa surface 321 qui est partiellement en contact avec la couche active 32.

La figure 4 est une vue en coupe d'un photodétecteur 4 selon un troisième mode de réalisation de l'invention qui intègre lui aussi une lentille convergente.

Le dimensionnement de ce photodétecteur est similaire à celui du photodétecteur de la figure 3.

Ce photodétecteur 4 comporte un substrat transparent 40 qui est de préférence rigide.

Ce substrat est gravé pour réaliser une cavité de forme convexe, qui est délimitée par une surface 400 également de forme convexe.

On peut également envisager de réaliser le substrat en une matière plastique souple, par moulage, de façon à ce qu'il comporte directement des évidements.

Sur cette paroi 400, est formée une couche 41 d'un matériau transparent d'épaisseur sensiblement constante. Cette couche 41 constitue la première électrode du photodétecteur et présente également une forme convexe.

Avant la formation de la couche 41, la paroi 400 pourrait subir un traitement de mouillabilité.

Une couche active 42 est ensuite déposée sur la première électrode 41. La couche active remplit le reste de la cavité formée dans le substrat 40 et s'étend au-delà de la surface 401 du substrat 40 sur laquelle débouche la cavité formée dans le substrat.

Ainsi, la couche active est délimitée par une paroi semi-sphérique 420 et une paroi sensiblement plane 421 qui ferme cette paroi 420.

Sur cette surface 421 est formée une deuxième électrode 43. Elle se présente sous la forme d'une couche plane et d'épaisseur sensiblement constante.

Enfin, les deux électrodes 41 et 43 sont isolées électriquement l'une de l'autre grâce à un isolant 44.

Le fonctionnement du photodétecteur 4 est le suivant.

C'est la surface 402 du substrat 40, opposée à la surface 401, qui est exposée au rayonnement lumineux. Il est symbolisé par les flèches identifiées R sur la figure 4.

Les rayons lumineux traversent le substrat 40 qui est transparent. La surface convexe 400 de la cavité formée dans le substrat agit comme une lentille convergente. Les rayons lumineux traversent ainsi l'électrode 41 transparente pour converger dans la partie active 42.

Ainsi, là encore, le photodétecteur 4 comporte une lentille qui est intégrée dans sa structure et qui est directement obtenue lors de sa fabrication. Grâce à la présence de cette lentille, les performances du photodétecteur sont augmentées.

Lorsque l'électrode 43 est réflectrice, les rayons lumineux qui n'ont pas été absorbés par la couche active sont réfléchis par l'électrode 43 et sont renvoyés dans la couche active.

Ceci permet d'augmenter encore les performances du photodétecteur.

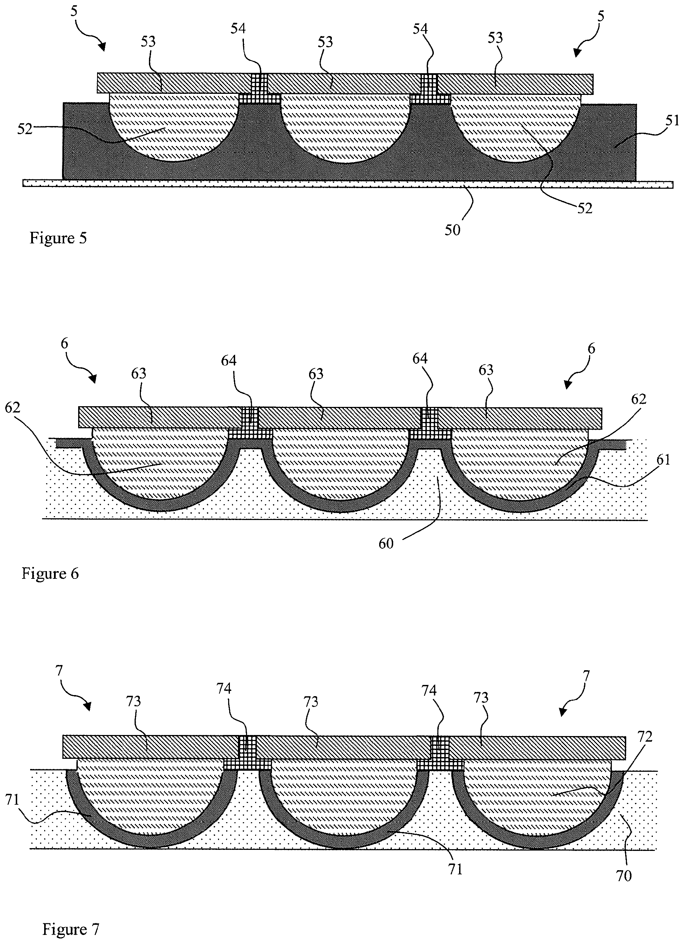

Il est maintenant fait référence aux figures 5 à 8 qui sont toutes des vues en coupe illustrant une matrice réalisée à partir de photodétecteurs selon l'invention.

La matrice illustrée sur la figure 5 comporte une pluralité de photodétecteurs 5, tels qu'illustrés sur la figure 3.

Ainsi, cette matrice comporte un substrat 50 transparent et une première électrode 51 également transparente, dans laquelle a été formée une pluralité de cavités (au nombre de 3 sur la figure 5).

Des couches actives 52 ont été formées dans ces cavités. Sur chaque couche active 52, est formée une deuxième électrode 53 qui présente une épaisseur sensiblement constante.

Toutes les électrodes 53 sont isolées l'une de l'autre par un isolant électrique 54.

Ainsi, dans la matrice illustrée à la figure 5, la première électrode 51 est commune à tous les photodétecteurs.

A titre d'illustration, la surface d'une couche active 52 en regard de l'une ou l'autre des électrodes 51 ou 53 est comprise entre 1 µm² et 1 mm².

La figure 6 illustre une autre matrice comportant une pluralité de photodétecteurs 6 similaires au photodétecteur 4 illustré à la figure 4.

Ainsi, cette matrice comporte un substrat 60 avec une pluralité de cavités semi-sphériques dans laquelle a été réalisée une première électrode 61.

Dans la matrice illustrée à la figure 6, la couche de matériau transparent formant la première électrode est déposée de manière continue d'une cavité à l'autre. Ainsi, cette matrice comporte une première électrode 61 qui est commune à tous les photodétecteurs de la matrice.

A titre d'illustration, la surface de la couche active 62 en regard de l'électrode 61 est comprise entre 1 µm² et 1 mm² selon l'application.

Chaque photodétecteur comporte également une couche active 62 formée sur la première électrode de façon à remplir la cavité réalisée dans le substrat.

Chaque partie active supporte une électrode 63 formée d'une couche plane et d'épaisseur sensiblement constante. Les électrodes 63 sont isolées électriquement l'une de l'autre ainsi que de la première électrode 61 par un matériau isolant 64.

La figure 7 illustre une variante de la figure 6, dans laquelle la première électrode n'est pas continue. Au contraire, chaque photodétecteur 7 comprend une première électrode 71 formée dans une cavité du substrat 71 qui est isolée électriquement de la première électrode d'un photodétecteur adjacent, grâce à un isolant électrique 74.

Cet isolant électrique 74 sert également à isoler l'une de l'autre les deuxièmes électrodes 73 formées sur les parties actives 72 des photodétecteurs.

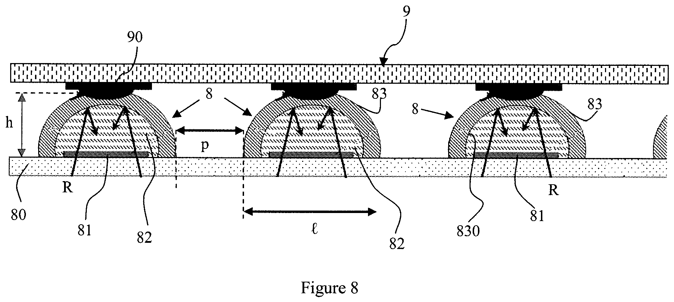

La matrice illustrée sur la figure 8 comporte une pluralité de photodétecteurs 8, tels qu'illustrés sur la figure 1.

Ainsi, cette matrice comporte un substrat plan et transparent 80, sur lequel est formée une pluralité de photodétecteurs 8 (au nombre de 3 sur la figure 5).

Chaque photodétecteur 8 comporte une électrode 81 transparente. Elle est plane et enrobée dans une couche active 82 de forme semi-sphérique.

La deuxième électrode 83 des photodétecteurs épouse la forme extérieure de la couche active 82 et présente donc également une forme convexe.

Cette électrode 83 présente un pouvoir réfléchissant au moins au niveau de son interface semi-sphérique 830 avec la couche active 82.

Dans l'exemple de réalisation illustré à la figure 8, une liaison électrique est réalisée au niveau des deuxièmes électrodes 83 par des moyens de connexion 9. Ces moyens de connexion peuvent consister en un autre substrat ou une couche isolante comportant des connexions 90 pour relier les deuxièmes électrodes.

A titre d'exemple de réalisation, les photodétecteurs 8 présentent une hauteur h comprise entre 100 nm et 1 µm.

Le pas p entre deux photodétecteurs 8 est compris entre 50 µm et 1 mm.

La largeur f de chaque photodétecteur, définie comme son emprise sur le substrat 80, est comprise entre 100 µm et 1 mm.

Enfin, le substrat 80 peut être réalisé en un polyéthylène naphthalate. Son épaisseur peut être d'environ 125 µm.

De façon générale, la première électrode des photodétecteurs selon l'invention peut notamment être déposée sur le substrat en mettant en oeuvre une technique de pulvérisation.

La couche active peut notamment être obtenue par jet d'encre ou par une technique de dispense. Pour obtenir un dépôt de forme semi-sphérique, la solution déposée doit présenter une viscosité suffisante.

De façon générale, la solution déposée étant à base d'un polymère et d'un solvant, la concentration du polymère constituant la couche active sera supérieure à 40 mg/ml.

A titre d'exemple, on peut utiliser une solution comportant 50 mg de PDOT/PSS dans 1 ml d'eau. Dans ce cas, le dépôt de cette solution par spray ou jet d'encre conduira au dépôt de gouttes de forme semi-sphérique.

L'obtention d'une forme semi-sphérique peut être favorisée en contrôlant l'énergie de surface du substrat. Ainsi, un traitement hydrophobe permet d'accentuer le caractère sphérique de la goutte déposée sur le substrat.

Lorsque la couche active comprend plusieurs couches, le premier dépôt conduit à la formation d'une semi-sphère, le dépôt suivant épouse cette forme et ainsi de suite.

Enfin, la deuxième électrode peut être formée par une technique de dépôt sous vide ou encore une technique d'impression.

Les signes de référence figurant dans les revendications ont pour seul but de faciliter leur compréhension et ne sauraient en limiter la portée.

## Revendications

1. Photodétecteur organique comprenant une première électrode (11, 21) plane et formée sur un substrat plan (10, 20), une couche active convexe (12, 22), formée sur la première électrode plane, et une deuxième électrode (13, 23) se présentant sous forme d'une couche qui épouse la forme extérieure de la couche active convexe et qui présente une forme convexe de sorte que la deuxième électrode (13, 23) agit comme une lentille convergente, des moyens pour concentrer le rayonnement lumineux dans la couche active étant intégrés dans le photodétecteur et étant représentés par la deuxième électrode (13, 23).

2. Photodétecteur selon la revendication 1, dans lequel la couche active (12, 22) est déposée sur la première électrode (11, 21) et l'enrobe.

3. Photodétecteur selon la revendication 2, dans lequel la première électrode (11) et le substrat (10) sont transparents et la deuxième électrode (13) est réfléchissante.

4. Photodétecteur selon la revendication 2, dans lequel la première électrode (21) est métallique et la deuxième électrode (23) est transparente.

5. Photodétecteur organique comprenant une première électrode (31) plane et formée sur un substrat plan et transparent (30), une couche active convexe (32), formée sur la première électrode plane, et une deuxième électrode (33) formée sur la couche active (32), des moyens pour concentrer le rayonnement lumineux dans la couche active étant intégrés dans le photodétecteur, dans lequel la première électrode (31) est évidée pour former une cavité convexe, ladite cavité comprenant une paroi (310) ayant une surface convexe de sorte que la surface convexe de la paroi (310) agit comme une lentille convergente, la couche active (32) étant déposée dans cette cavité, sur la première électrode, et dans lequel lesdits moyens étant représentés par la surface convexe de la paroi (310) de ladite cavité.

6. Photodétecteur organique comprenant une première électrode (41) formée sur un substrat plan (40), une couche active convexe (42), formée sur la première électrode (41), et une deuxième électrode (43) formée sur la couche active convexe (42), des moyens pour concentrer le rayonnement lumineux dans la couche active étant intégrés dans le photodétecteur, dans lequel le substrat (40) est transparent et évidé pour former une cavité convexe comprenant une surface convexe (400), la première électrode (41) est convexe et consiste en une couche déposée dans ladite cavité convexe de sorte que la surface convexe de la cavité agit comme une lentille convergente et la couche active (42) est déposée dans la cavité, sur la première électrode, et dans lequel lesdits moyens étant représentés par la surface convexe (400) de ladite cavité.

7. Photodétecteur selon la revendication 5 ou 6, dans lequel la deuxième électrode (33, 43) est plane.

8. Photodétecteur selon l'une des revendications 5 à 7, dans lequel un isolant électrique est prévu entre les première et deuxième électrodes.

9. Matrice comportant une pluralité de photodétecteurs selon l'une des revendications 1 à 8.

10. Matrice selon la revendication 9, dans laquelle les photodétecteurs (5, 6) comportent une couche active (52, 62) formée dans une cavité de la première électrode (51) ou du substrat (60), dans lequel la première électrode (51, 61) est commune à tous les photodétecteurs.

11. Matrice selon la revendication 9, dans laquelle les photodétecteurs (7) comportent une couche active dans une cavité formée dans le substrat (70), les photodétecteurs (7) étant isolés électriquement les uns des autres.

## Patentansprüche

1. Organischer Photodetektor, umfassend eine ebene und auf einem ebenen Substrat (10, 20) gebildete erste Elektrode (11, 21), eine konvexe aktive Schichte (12, 22), die auf der ebenen ersten Elektrode gebildet ist, und eine zweite Elektrode (13, 23), die sich unter der Form einer Schicht gestaltet, die sich der äußeren Form der konvexen aktiven Schicht vollkommen anpasst, und die eine konvexe Form aufweist, sodass die zweite Elektrode (13, 23) als eine Sammellinse wirkt, wobei Mittel zum Konzentrieren der Lichtstrahlung in der aktiven Schicht im Photodetektor eingebaut sind und durch die zweite Elektrode (13, 23) dargestellt sind.

2. Photodetektor nach Anspruch 1, wobei die aktive Schicht (12, 22) auf der ersten Elektrode (11, 21) abgeschieden wird und diese umgibt.

3. Photodetektor nach Anspruch 2, wobei die erste Elektrode (11) und das Substrat (10) transparent sind und die zweite Elektrode (13) reflektierend ist.

4. Photodetektor nach Anspruch 2, wobei die erste Elektrode (21) aus Metall ist und die zweite Elektrode (23) transparent ist.

5. Organischer Photodetektor, umfassend eine ebene und auf einem ebenen und transparenten Substrat (30) gebildete erste Elektrode (31), eine konvexe aktive Schichte (32), die auf der ebenen ersten Elektrode gebildet ist, und eine zweite Elektrode (33), die auf der aktiven Schicht (32) gebildet ist, wobei Mittel zum Konzentrieren der Lichtstrahlung in der aktiven Schicht im Photodetektor eingebaut sind, wobei die erste Elektrode (31) ausgehöhlt ist, um einen konvexen Hohlraum zu bilden, wobei der Hohlraum eine Wand (310) umfasst, die eine konvexe Oberfläche besitzt, sodass die konvexe Oberfläche der Wand (310) als eine Sammellinse wirkt, wobei die aktive Schicht (32) in diesem Hohlraum auf der ersten Elektrode abgeschieden wird, und wobei die Mittel durch die konvexe Oberfläche der Wand (310) des Hohlraums dargestellt sind.

6. Organischer Photodetektor, umfassend eine erste Elektrode (41), die auf einem ebenen Substrat (40) gebildet ist, eine konvexe aktive Schicht (42), die auf der ersten Elektrode (41) gebildet ist, und eine zweite Elektrode (43), die auf der konvexen aktiven Schicht (42) gebildet ist, wobei Mittel zum Konzentrieren der Lichtstrahlung in der aktiven Schicht im Photodetektor eingebaut sind, wobei das Substrat (40) transparent und ausgehöhlt ist, um einen konvexen Hohlraum zu bilden, der eine konvexe Oberfläche (400) umfasst, wobei die erste Elektrode (41) konvex ist und aus einer im konvexen Hohlraum abgeschiedenen Schicht besteht, sodass die konvexe Oberfläche des Hohlraums als eine Sammellinse wirkt und die aktive Schicht (42) im Hohlraum auf der ersten Elektrode abgeschieden wird, und wobei die Mittel durch die konvexe Oberfläche (400) des Hohlraums dargestellt sind.

7. Photodetektor nach Anspruch 5 oder 6, wobei die zweite Elektrode (33, 43) eben ist.

8. Photodetektor nach einem der Ansprüche 5 bis 7, wobei ein elektrischer Isolator zwischen der ersten und zweiten Elektrode vorgesehen ist.

9. Matrix, umfassend eine Vielzahl von Photodetektoren nach einem der Ansprüche 1 bis 8.

10. Matrix nach Anspruch 9, wobei die Photodetektoren (5, 6) eine aktive Schicht (52, 62) beinhalten, die in einem Hohlraum der ersten Elektrode (51) oder des Substrats (60) gebildet ist, wobei die erste Elektrode (51, 61) allen Photodetektoren gemein ist.

11. Matrix nach Anspruch 9, wobei die Photodetektoren (7) eine aktive Schicht in einem im Substrat (70) gebildeten Hohlraum beinhalten, wobei die Photodetektoren (7) elektrisch voneinander isoliert sind.

## Claims

1. Organic photodetector comprising a first planar electrode (11, 21) formed on a planar substrate (10, 20), a convex active layer (12, 22) formed on the first planar electrode, and a second electrode (13, 23) in the form of a layer which conforms to the outer shape of the convex active layer and has a convex shape such that the second electrode (13, 23) acts as a converging lens, means for concentrating light radiation in the active layer being incorporated into the photodetector and represented by the second electrode (13, 23).

2. Photodetector according to claim 1, wherein the active layer (12, 22) is deposited on the first electrode (11, 21) and coats it.

3. Photodetector according to claim 2, wherein the first electrode (11) and the substrate (10) are transparent, and the second electrode (13) is reflective.

4. Photodetector according to claim 2, wherein the first electrode (21) is made of metal and the second electrode (23) is transparent.

5. Organic photodetector comprising a first planar electrode (31) formed on a planar and transparent substrate (30), a convex active layer (32) formed on the first planar electrode, and a second electrode (33) formed on the active layer (32), means for concentrating light radiation in the active layer being incorporated into the photodetector, wherein the first electrode (31) is indented in order to form a convex cavity, said cavity comprising a wall (310) which has a convex surface such that the convex surface of the wall (310) acts as a converging lens, the active layer (32) being deposited in this cavity, on the first electrode, and wherein said means are represented by the convex surface of the wall (310) of said cavity.

6. Organic photodetector comprising a first electrode (41) formed on a planar substrate (40), a convex active layer (42) formed on the first electrode (41), and a second electrode (43) formed on the convex active layer (42), means for concentrating light radiation in the active layer being incorporated into the photodetector, wherein the substrate (40) is transparent and indented in order to form a convex cavity comprising a convex surface (400), the first electrode (41) is convex and consists of a layer deposited in said cavity such that the convex surface of the cavity acts as a converging lens and the active layer (42) is deposited in the cavity, on the first electrode, and wherein said means are represented by the convex surface (400) of said cavity.

7. Photodetector according to claim 5 or 6, wherein the second electrode (33, 43) is planar.

8. Photodetector according to any one of claims 5 to 7, wherein an electrical insulator is provided between the first and second electrodes.

9. Array comprising a plurality of photodetectors according to any one of claims 1 to 8.

10. Array according to claim 9, wherein the photodetectors (5, 6) comprise an active layer (52, 62) formed in a cavity of the first electrode (51) or of the substrate (60), wherein the first electrode (51, 61) is common to all of the photodetectors.

11. Array according to claim 9, wherein the photodetectors (7) comprise an active layer in a cavity formed in the substrate (70), with the photodetectors (7) being electrically insulated from one another.
